# EUROPÄISCHE PATENTSCHRIFT

(11) **EP 3 388 848 B1**
(45) Veröffentlichungstag und Bekanntmachung des Hinweises auf die Patenterteilung: **28.10.2020**
(21) Anmeldenummer: 17165889.1
(22) Anmeldetag: 11.04.2017
(51) Int. Cl.: G01R 31/50, G01R 27/04

(54) **VERFAHREN, MESSEINRICHTUNG UND MESSSYSTEM, ZUM ERMITTELN ZUMINDEST EINER DIAGNOSEGRÖSSE IN EINEM ELEKTRISCHEN ENERGIEVERSORGUNGSNETZ**
METHOD, MEASURING DEVICE AND MEASURING SYSTEM, FOR DETERMINING AT LEAST ONE DIAGNOSIS VARIABLE IN A POWER DISTRIBUTION NETWORK
PROCÉDÉ, DISPOSITIF DE MESURE ET SYSTÈME DE MESURE, POUR LA DÉTERMINATION D'AU MOINS UNE VALEUR DE DIAGNOSTIC DANS UN RÉSEAU DE DISTRIBUTION ÉLECTRIQUE

(43) Veröffentlichungstag der Anmeldung: 17.10.2018
(73) Patentinhaber: Siemens Aktiengesellschaft, 80333 München (DE)
(72) Erfinder: Fröhner, Wiebke, 92224 Amberg (DE); Mladenovic, Ivana, 90556 Seukendorf (DE); Werner, Thomas, 91126 Rednitzhembach (DE)

(56) Entgegenhaltungen:
- CN-A- 101 494 374
- CN-A- 102 879 716
- DE-A1-102012 016 686
- DE-A1-102015 014 820
- JP-A- 2009 176 107
- KR-A- 20100 104 139
- US-A- 4 846 130
- US-A1- 2007 279 041
- US-A1- 2010 102 824
- US-A1- 2010 301 872
- US-A1- 2012 299 603

## Beschreibung

Die Erfindung betrifft ein Verfahren zum Ermitteln zumindest einer Diagnosegröße, die einen Alterungszustand eines Betriebsmittels in einem elektrischen Energieversorgungsnetz angibt, bei dem an einer ersten Messstelle des Betriebsmittels erste Messwerte zumindest einer Messgröße erfasst werden, an einer zweiten Messstelle des Betriebsmittels zweite Messwerte der zumindest einen Messgröße erfasst werden, und unter Verwendung jeweils gleichzeitig erfasster erster und zweiter Messwerte die zumindest eine Diagnosegröße ermittelt wird.

Elektrische Betriebsmittel in Energieversorgungsnetzen, wie beispielsweise Transformatoren, Kabel oder Leitungen, sind durch elektrische Belastungen (z.B. hohe Spannungen und Ströme, Fehlerzustände) im Betrieb aber auch durch äußere Einflüsse (wie mechanische Belastungen, Temperaturschwankungen, extreme Temperaturen, Sonneneinstrahlung, Feuchtigkeit, Frost und ähnliche Einflüsse) einem beständigen Alterungsprozess unterworfen und müssen zur Vorsorge regelmäßig überprüft, gewartet und ausgetauscht werden, um den ordnungsgemäßen Betrieb des Energieversorgungsnetzes zu gewährleisten.

In heutigen elektrischen Energieversorgungsnetzen ist die automatische Überwachung des Alterungszustandes eines elektrischen Betriebsmittels sehr aufwendig und teuer. Aus diesem Grund werden im Allgemeinen nur sehr große und/oder sehr hochwertige Betriebsmittel, wie zum Beispiel Transformatoren in Hochspannungsnetzen, mit entsprechenden Sensoren und Auswertesystemen ausgerüstet, die in Echtzeit eine Überwachung und Diagnose des Alterungszustandes erlauben. Häufig wird dabei auch nicht das gesamte Betriebsmittel betrachtet, sondern es werden nur ausgewählte Komponenten überwacht.

Während in Hochspannungs-Übertragungsnetzen eine automatische Überwachung und Diagnose von Betriebsmitteln daher noch vergleichswiese häufig stattfindet, ist in Verteilnetzen der Mittel- und Niederspannungsebene eine online-Überwachung, also eine Überwachung während des laufenden Betriebs, dagegen aus Kostengründen eher unüblich. Wenige ausgesuchte Betriebsmittel werden dort mit Hilfe von speziellen Diagnosesystemen untersucht, wobei sie für die Untersuchung aus dem Betrieb genommen werden müssen. Für die diagnostische Zwecke wurden unterschiedliche Methoden entwickelt, die für spezifische Betriebsmittel jeweils am besten geeignet sind. Diese basieren meistens auf offline durchgeführte Messungen, d.h. im Feld befindliche und zu diagnostizierende Betriebsmittel werden hierfür zuerst aus dem Betrieb genommen.

Die wenigen online durchführbaren diagnostischen Methoden sind zudem spezifisch für die Betriebsmittel. Meistens trifft man auf Teilentladungsmessungen, die Schwachstellen in den Isolationsmedien identifizieren sollen. Ein Beispiel einer Methode zur Bestimmung des Alterungszustandes von Betriebsmitteln wie Transformatoren oder Generatoren ist aus der EP 1623240 A2 bekannt.

Die Messung von Teilentladungen kann auch zur Überwachung von Kabeln eingesetzt werden. Eine weitere Möglichkeit für eine online durchführbare Diagnose besteht in einer Verlustfaktormessung. Beispielhaft sei die WO 2012/162486 A2 genannt, die eine online durchführbare Überwachung des Alterungszustands eines Kabels beschreibt, wobei allerdings eine aufwändige Messtechnik erforderlich ist, um eine Zeitsynchronität der Messungen an verschiedenen Leitungsenden zu ermöglichen. Bei dem bekannten Verfahren wird die Synchronisation mittels eines Synchronisierungsgerätes mit Satellit-Uhren, die eine Genauigkeit von maximal ±40ns aufweisen, erreicht. Zudem erfordert diese Lösung einen hohen Kommunikationsaufwand zwischen den zur Messung eingesetzten Detektoren und einer zentralen Auswerteeinheit. Weitere Beispiele für Vorrichtungen zum Überwachen eines Betriebsmittels in einem elektrischen Energieversorgungsnetz, sind in den Druckschriften DE 10 2012 016686 A1, US 2010/102824 A1 und CN 102 879 716 A offenbart.

Es wäre jedoch wünschenswert, auch in Verteilnetzen den Alterungszustand der Betriebsmittel genauer zu kennen, um Wartungs- und Instandhaltungsmaßnahmen optimal planen zu können. Zusätzlich wäre es vorteilhaft, diese Zustände ohne Unterbrechung des Betriebes ermitteln zu können.

Aufgabe der Erfindung ist damit, eine ohne Unterbrechung des Betriebsablaufs eines Betriebsmittels durchführbare und vergleichsweise einfache Ermittlung eines Alterungszustands des Betriebsmittels anzugeben.

Zur Lösung dieser Aufgabe wird ein Verfahren der eingangsgenannten Art vorgeschlagen, bei dem die Erfassung der ersten und zweiten Messwerte zeitgesteuert in der Weise erfolgt, dass ein Signal der zumindest einen Messgröße mit einer vorgegebenen Abtastrate zu festgelegten Zeitpunkten und während einer festgelegten Messdauer unter Erzeugung von zeitlichen Verläufen der ersten und zweiten Messwerte abgetastet werden.

Auf diese Weise kann vorteilhaft erreicht werden, dass die Erfassung der für die Berechnung der Diagnosegröße erforderlichen Messwerte keine aufwendige Synchronisation stattfinden muss. Vielmehr ist bereits im Vorfeld festgelegt, zu welchen Zeitpunkten eine Erfassung der Messwerte startet und wie lange sie dauert.

Die vorgegebene Abtastrate sollte hierbei für die Ermittlung der zumindest einen Diagnosegröße angemessen sein. Beispielsweise kann sie 1 Million Abtastwerte pro Sekunde betragen. Andere Abtastraten sind jedoch ebenso möglich. Hierdurch kann eine Erfassung der Messwerte mit einer für die Berechnung der Diagnosegröße optimalen zeitlichen Auflösung erfolgen.

Gemäß einer vorteilhaften Ausführungsform des erfindungsgemäßen Verfahrens ist zudem vorgesehen, dass - die festgelegten Zeitpunkte und/oder die festgelegte Messdauer durch eine Konfiguration vorgegeben wird.

Hierbei kann beispielsweise eine bei der Inbetriebnahme einer Messeinrichtung erforderliche Konfiguration durch Eingabe entsprechender Einstellwerte hinsichtlich der zu verwendenden Zeitpunkte und Messdauern spezifisch angepasst werden.

Gemäß einer weiteren vorteilhaften Ausführungsform des erfindungsgemäßen Verfahrens wird vorgeschlagen, dass als Messgröße ein elektrischer Strom, eine elektrische Spannung und/oder ein Phasenwinkel an der ersten und zweiten Messstelle des Betriebsmittels verwendet werden.

Auf diese Weise kann durch Erfassung in elektrischen Energieversorgungsnetzen üblicher Messgrößen eine Diagnosegröße gebildet werden, die einen Aufschluss auf den Alterungszustand des Betriebsmittels erlaubt.

Konkret kann hierbei vorgesehen sein, dass - die zumindest eine Diagnosegröße in Form eines Verlustfaktors des Betriebsmittels oder einer charakteristischen Impedanz eines Systemersatzschaltbildes des Betriebsmittels ermittelt wird.

Der Verlustfaktor (englisch "dissipation factor") beschreibt quasi die elektrischen Verluste innerhalb des Betriebsmittels, die beispielsweise durch Umwandlung elektrischer Energie durch Dissipation in Wärme erfolgt. Der Verlustfaktor ermittelt sich als Tangens des Verlustwinkels δ zwischen einer komplexen elektrischen Größe (z.B. Strom) und ihrem Imaginärteil. Somit kann durch Angabe des Verlustfaktors, und insbesondere durch Beobachtung einer Veränderung des Verlustfaktors über die Zeit, eine geeignete Angabe über den Alterungszustand eines Betriebsmittels gegeben werden.

Eine charakteristische Impedanz ist diejenige Impedanz, die das entsprechende Ersatzschaltbild (Systemersatzschaltbild) des Betriebsmittels angibt und insbesondere das Betriebsmittel und sein Isolationssystem beschreibt.

Gemäß einer möglichen Ausführungsform des erfindungsgemäßen Verfahrens ist vorgesehen, dass die erste und die zweite Messstelle des Betriebsmittels in räumlicher Nähe zueinander angeordnet sind, und die ersten und zweiten Messwerte mittels einer einzelnen Messeinrichtung erfasst werden, die in räumlicher Nähe zu den Messstellen angeordnet ist.

Unter "in räumlicher Näher zueinander angeordnet" soll hierbei eine Anordnung der Messstellen angesehen werden, die es erlaubt, mit vertretbarem Aufwand hinsichtlich elektrischer Verkabelung die jeweiligen Messwerte mit einer einzigen Messeinrichtung zu erfassen. Üblicherweise sind die Messstellen am Eingang und Ausgang eines lokalen Betriebsmittels, wie beispielsweise eines Transformators, eines Motors oder eines Generators, in räumlicher Nähe zueinander angeordnet, da es ohne großen Aufwand möglich ist, die an diesen Messstellen aufgenommenen Signale der elektrischen Messgrößen mittels einer einzigen Messeinrichtung, die über Verkabelung mit den Messsensoren der jeweiligen Messstelle verbunden ist, zu erfassen. In diesem Fall wird die Erfassung der über die Verkabelung an die Messeinrichtung herangeführten Signale der Messgrößen durch zeitgesteuerte Abtastung der Signale unter Bildung der Messwerte in der Messeinrichtung durchgeführt.

Eine andere Ausführungsform des erfindungsgemäßen Verfahrens sieht vor, dass die erste und die zweite Messstelle des Betriebsmittels räumlich voneinander entfernt angeordnet sind, und die ersten Messwerte mittels einer ersten Messeinrichtung und die zweiten Messwerte mittels einer zweiten Messeinrichtung erfasst werden.

Bei dieser Ausführungsform liegt im Unterschied zur vorigen Ausführungsform kein lokales Betriebsmittel vor, vielmehr wird die Messung an einem räumlich verteilten Betriebsmittel, wie z.B. einem unterirdisch verlegten Kabel oder eine überirdisch verlaufenden Freileitung, durchgeführt, bei dem die Messstellen so weit auseinanderliegen, dass eine Erfassung der Signale der Messgrößen mit einer einzigen Messeinrichtung nicht nur unpraktikabel, sondern auch mit Messfehlern behaftet ist, die durch die Übertragung der Signale über lange Distanzen entstehen. So kann es bei Kabeln in Verteilnetzen durchaus vorkommen, dass die Messstellen in einer Entfernung von einigen Kilometern zueinander liegen. Bei einer solchen räumlich auseinander liegenden Anordnung der Messstellen werden die Messwerte folglich mit zwei Messeinrichtungen erfasst.

In diesem Zusammenhang ist gemäß einer vorteilhaften Ausführungsform des erfindungsgemäßen Verfahrens vorgesehen, dass die erste und die zweite Messeinrichtung jeweils einen Zeitgeber umfassen, der die zeitgesteuerte Erfassung der Messwerte steuert.

Hierdurch kann erreicht werden, dass eine Erfassung von zeitlich zueinander gehörenden Messwerten stattfindet, aus denen sich die Diagnosegröße ermitteln lässt. Jede der beiden Messeinrichtungen führt hierbei über ihren Zeitgeber gesteuert die Erfassung der Messwerte durch.

Konkret kann in diesem Zusammenhang vorgesehen sein, dass der jeweilige Zeitgeber mittels eines Synchronisiersignals auf eine externe Zeitquelle abgestimmt wird.

Auf diese Weise kann nämlich erreicht werden, dass die Zeitgeber in den Messeinrichtungen zeitlich möglichst gut aufeinander abstimmt sind, so dass eine Erfassung zeitlich zueinander gehörender Messwerte vereinfacht wird.

Außerdem sieht eine weitere vorteilhafte Ausführungsform in diesem Zusammenhang vor, dass die festgelegten Zeitpunkte und Messdauern zur Erfassung der Messwerte der ersten und der zweiten Messwerte zeitlich derart festgelegt werden, dass die zeitgesteuerte Erfassung der Messwerte zumindest während eines Überlappungs-Zeitbereichs in den beiden Messeinrichtungen gleichzeitig erfolgt.

Hierbei findet vorteilhaft die zeitgesteuerte Erfassung der Messwerte derart statt, dass während der von der jeweiligen Messeinrichtung erfassten Messwerte immer zumindest einige Messwerte an beiden Messstellen gleichzeitig zueinander erfasst werden. Die Zeitdauern, während denen an den beiden Messstellen die Messwerte erfasst werden, können somit durchaus zu unterschiedlichen absoluten Zeitpunkten beginnen und unterschiedliche Längen zeitliche aufweisen, es ist für die Auswertung ausreichend, wenn sie lediglich einen Überlappungsbereich aufweisen, innerhalb dessen an beiden Messstellen - zeitlich absolut gesehen - gleichzeitig Messwerte erfasst werden.

In diesem Zusammenhang kann konkret beispielsweise vorgesehen sein, dass die Verläufe der ersten und zweiten Messwerte abgespeichert und durch nachträgliche Synchronisierung aus den Verläufen jeweils gleichzeitig erfasste Messwertpaare der zumindest einen Messgröße ermittelt werden.

Diese Ausführungsform besitzt den Vorteil, dass auch bei nicht hochgenau miteinander synchronisierten Zeitgebern des Messeinrichtungen aus den abgespeicherten Verläufen diejenigen Messwerte ermittelt werden können, die tatsächlich zu - absolut gesehen - gleichen Messzeitpunkten erfasst worden sind. Dadurch dass die Synchronisation nachträglich anhand der abgespeicherten Verläufe durchgeführt wird und nicht durch aufwendige Maßnahmen hinsichtlich der Zeitgeber der Messeinrichtungen im Voraus vorgesehen sein muss, ist es möglich, verhältnismäßig günstige - dadurch allerdings auch ungenauere - Zeitgeber zu verwenden. Ein Beispiel eines kostengünstigen Zeitgebers, der in einer erfindungsgemäßen Messeinrichtung verwendet werden kann, ist ein im Umfeld von Funkuhren verwendeter Zeitgeber, dessen Uhrzeit mit einem DCF77-Signal, das per Langwelle ausgestrahlt wird, eingestellt wird. Die Genauigkeit eines solchen Zeitgebers liegt etwa bei 100 ms, was für hochgenaue Messungen im Umfeld von Energieversorgungsnetzen an sich zu ungenau wäre. Durch die nachträgliche Synchronisierung lassen sich jedoch Unterschide der Uhrzeiten beider Zeitgeber vergleichsweise einfach ausgleichen.

In diesem Zusammenhang kann beispielsweise vorgesehen sein, dass zur nachträglichen Synchronisierung aus den Verläufen der ersten und zweiten Messwerte jeweils die erste zeitliche Ableitung gebildet wird, in jedem Verlauf der abgeleiteten Messwerte das Maximum und der zugehörige Zeitpunkt, zu dem das Maximum in dem jeweiligen Verlauf auftritt, ermittelt werden, und diejenigen Messwerte, die zum Zeitpunkt des jeweiligen Maximums erfasst worden sind, als gleichzeitig erfasstes Messwertpaar verwendet werden.

Auf diese Weise kann mit einfachen mathematischen Mitteln, nämlich lediglich durch Bildung der ersten Ableitung des Verlaufs, eine nachträgliche zeitliche Synchronisation durchgeführt werden. Hierbei wird der Effekt ausgenutzt, dass durch äußere Einflüsse, z.B. durch ein Rauschen auf den zu messenden Signalen der Messgrößen, auf die Amplituden der Signale ein Muster aufgeprägt wird, das sich gleichzeitig an beiden Messstellen erkennen lässt. Werden durch Gradientenbildung diese Effekte kenntlich gemacht, so können sie zur Synchronisation der Messwerte herangezogen werden, indem diejenigen Messwerte der Verläufe, die zum jeweiligen Zeitpunkt des größten Gradienten erfasst worden sind, als gleichzeitig erfasst angenommen werden.

Eine weitere vorteilhafte Ausführungsform des erfindungsgemäßen Verfahrens sieht hierbei vor, dass mindestens dasjenige Messwertpaar, das zum Zeitpunkt des jeweiligen Maximums erfasst worden ist, an eine Auswertungseinrichtung übermittelt werden, und mit der Auswertungseinrichtung die Diagnosegröße ermittelt wird.

Die Auswertungseinrichtung kann hierbei eine separate Einrichtung oder Bestandteil einer der Messeinrichtungen sein. Die Diagnosegröße kann hierbei auf Grundlage eines Messwertpaares oder mehrerer Messwertpaare ermittelt werden. Dadurch dass zumindest das durch die nachträgliche Synchronisierung ermittelte Messwertpaar als gleichzeitig erfasst erkannt worden ist, können auch die umliegenden Messwerte entsprechend zeitlich einander zugeordnet werden.

Die oben genannte Aufgabe wird auch durch eine Messeinrichtung zum Erfassen von Messwerten in einem elektrischen Energieversorgungsnetz gelöst, die eine Abtasteinrichtung zur Abtastung eines Signals zumindest einer elektrischen Messgröße unter Verwendung einer vorgegebenen Abtastrate aufweist.

Erfindungsgemäß sind ein Zeitgeber, der dazu eingerichtet ist, die Erfassung der Messwerte zeitgesteuert in der Weise durchzuführen, dass das Signal der Messgröße mit einer vorgegebenen Abtastrate zu festgelegten Zeitpunkten und während einer festgelegten Messdauer unter Erzeugung eines zeitlichen Verlaufs der Messwerte abgetastet werden, sowie eine Speichereinrichtung zum Abspeichern der Verläufe der Messwerte vorgesehen.

Hinsichtlich der erfindungsgemäßen Messeinrichtung gelten alle zu dem erfindungsgemäßen Verfahren voranstehend und nachfolgend gemachten Ausführungen und umgekehrt in entsprechender Weise, insbesondere ist die erfindungsgemäße Messeinrichtung zur Durchführung des erfindungsgemäßen Verfahrens in jeder beliebigen Ausführungsform oder einer Kombination beliebiger Ausführungsformen eingerichtet. Auch hinsichtlich der Vorteile der erfindungsgemäßen Messeinrichtung wird auf die zu dem erfindungsgemäßen Verfahren beschriebenen Vorteile verwiesen.

Außerdem wird die oben genannte Aufgabe durch ein Messsystem zum Ermitteln zumindest einer Diagnosegröße mit zumindest zwei nach Anspruch 13 ausgebildeten Messeinrichtungen gelöst, das eine Synchronisiereinrichtung aufweist, die dazu ausgebildet ist, durch nachträgliche Synchronisierung aus den Verläufen der Messwerte jeweils gleichzeitig in den Messeinrichtungen erfasste Messwertpaare zu ermitteln, indem sie in jedem Verlauf der Messwerte jeweils die erste zeitliche Ableitung bildet, in jedem Verlauf der abgeleiteten Messwerte das Maximum ermittelt und diejenigen Messwerte, die zum Zeitpunkt des jeweiligen Maximums erfasst worden sind, als gleichzeitig erfasstes Messwertpaar verwendet, und das eine Analyseeinrichtung aufweist, die dazu eingerichtet ist, die zumindest eine Diagnosegröße zumindest aus dem gleichzeitig erfassten Messwertpaar zu ermitteln.

Hinsichtlich des erfindungsgemäßen Messsystems gelten alle zu dem erfindungsgemäßen Verfahren voranstehend und nachfolgend gemachten Ausführungen und umgekehrt in entsprechender Weise, insbesondere ist die erfindungsgemäße Messsystem zur Durchführung des erfindungsgemäßen Verfahrens in jeder beliebigen Ausführungsform oder einer Kombination beliebiger Ausführungsformen eingerichtet. Auch hinsichtlich der Vorteile des erfindungsgemäßen Messsystems wird auf die zu dem erfindungsgemäßen Verfahren beschriebenen Vorteile verwiesen.

Die Erfindung wird nachfolgend anhand eines Ausführungsbeispiels näher erläutert. Die spezifische Ausgestaltung des Ausführungsbeispiels ist für die allgemeine Ausgestaltung des erfindungsgemäßen Verfahrens und der erfindungsgemäßen Einrichtung in keiner Weise einschränkend zu verstehen; vielmehr können einzelne Ausgestaltungsmerkmale des Ausführungsbeispiels in beliebiger Weise frei untereinander und mit den voranstehend beschriebenen Merkmalen kombiniert werden.

Es zeigen
- Figur 1: ein erstes Ausführungsbeispiel eines Messsystems zur Ermittlung zumindest einer Diagnosegröße, bei dem die Messstellen in räumlicher Nähe zueinander angeordnet sind;
- Figur 2: ein zweites Ausführungsbeispiel eines Messsystems zur Ermittlung zumindest einer Diagnosegröße, bei dem die Messstellen in räumlicher Nähe zueinander angeordnet sind;
- Figur 3: ein erstes Ausführungsbeispiel eines Messsystems zur Ermittlung zumindest einer Diagnosegröße, bei dem die Messstellen räumlich voneinander entfernt angeordnet sind;
- Figur 4: ein zweites Ausführungsbeispiel eines Messsystems zur Ermittlung zumindest einer Diagnosegröße, bei dem die Messstellen räumlich voneinander entfernt angeordnet sind;
- Figur 5: Diagramme mit Verläufen von Strommesswerten, die an zwei Messstellen aufgenommen worden sind, zur Erläuterung einer nachträglichen zeitlichen Synchronisation.
- Figur 6: ein Ersatzschaltbild eines elektrischen Kabels zur Erläuterung des Verlustfaktors; und
- Figur 7: ein Diagramm zur Erläuterung der Ermittlung eines Verlustfaktors.

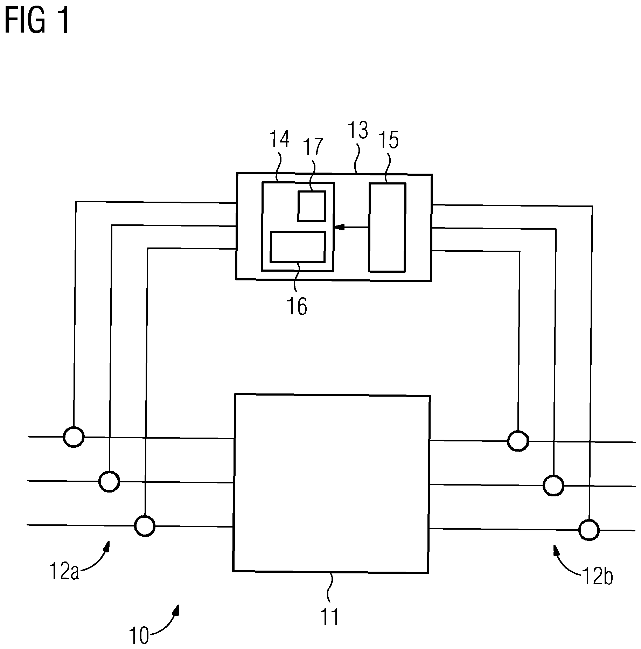

Figur 1 zeigt in schematischer Darstellung ein Messsystem 10, mit dem eine Diagnosegröße zur Angabe eines Alterungszustands eines elektrischen Betriebsmittels 11, z.B. eines Transformators, in einem nicht weiter dargestellten elektrischen Energieversorgungsnetz ermittelt werden soll. Hierzu sind zwei Messstellen 12a und 12b vorgesehen, an denen mit lediglich schematisch angedeuteten Messaufnehmern, z.B. Strom- und/oder Spannungswandlern Signale elektrischer Messgrößen, z.B. Ströme und/oder Spannungen, erfasst werden. Die Signale werden daraufhin einer Messeinrichtung 13 zugeführt, mit der daraus die zumindest eine Diagnosegröße bestimmt wird.

Die Messeinrichtung 13 weist eine Abtasteinrichtung 14 auf, die mit einem Abtasttakt, z.B. mit einer Abtastrate von 1 Million Abtastwerten (Samples) pro Sekunde, beaufschlagt ist und die Signale unter Gewinnung von Messwerten abtastet. Konkret wird das von der ersten Messstelle 12a stammende Signal der zumindest einen Messgröße unter Gewinnung von ersten Messwerten abgetastet, während das von der zweiten Messstelle 12b stammende Signal 12b der zumindest einen Messgröße unter Gewinnung von zweiten Messwerten abgetastet wird.

Die Abtastung erfolgt zeitgesteuert durch einen Zeitgeber 15, der zu einem vorbestimmten Zeitpunkt ein Startsignal an die Abtasteinrichtung 14 übermittelt und diese zur Abtastung der Signale der beiden Messstellen 12a, 12b veranlasst. Die Abtastung wird während einer vorbestimmten Messdauer durchgeführt. Die Messdauer kann entweder in der Abtasteinrichtung oder in dem Zeitgeber 15 eingestellt sein. Im letztgenannten Fall übermittelt der Zeitgeber 15 auch ein Stoppsignal an die Abtasteinrichtung 14, um die Erfassung der ersten und zweiten Messwerte zu beenden. Die Erfassung wird daraufhin zu einem folgenden vorbestimmten Zeitpunkt erneut durchgeführt. Beispielsweise kann auf diese Weise eingestellt sein, dass eine Erfassung der ersten und zweiten Messwerte alle 24 Stunden für eine Messdauer von 2 Sekunden stattfinden soll. Andere Einstellungen sind ebenso möglich.

Die Festlegung der Abtastzeitpunkte und der Messdauer kann z.B. während einer Konfiguration der Messeinrichtung 13 als Einstellwert vorgegeben werden.

Bei der Ausführungsform gemäß Figur 1 sind die Messstellen 12a und 12b in räumlicher Nähe zueinander an einem lokalen Betriebsmittel angeordnet. Beispielsweise kann die Messstelle 12a am Eingang des Betriebsmittels 11 und die Messstelle 12b am Ausgang des Betriebsmittels angeordnet sein.

Bei der Diagnosegröße kann es sich beispielsweise um einen Verlustfaktor oder eine charakteristische Impedanz des Systemersatzschaltbildes des Betriebsmittels handeln. Anhand eines Verlustfaktors lässt sich die Alterung des Betriebsmittels besonders gut feststellen. Alternativ können auch andere Diagnosegrößen, z.B. komplexe Impedanzen, ermittelt werden oder weitere Größen daraus abgeleitet werden.

Insbesondere kann durch Vergleich zeitlich nacheinander ermittelter Diagnosegrößen, z.B. über den Verlauf eines Jahres betrachtet, eine Veränderung der Diagnosegröße und damit eine voranschreitende Alterung des Betriebsmittels erkannt werden. Es kann ein Schwellenwert für die Diagnosegröße festgelegt sein, ab dessen Erreichen ein kritischer Alterungszustand des Betriebsmittels festgestellt wird. Auch können mehrere Schwellenwerte festgelegt sein, um verschiedene Abstufungen des Alterungszustands ermitteln zu können.

Die Ermittlung der Diagnosegröße findet bei dem Ausführungsbeispiel gemäß Figur 1 in der Messeinrichtung 13 selbst statt. Hierzu weist die Messeinrichtung 13 eine Auswertungseinrichtung 16 auf, die unter Verwendung der ersten und zweiten Messwerte die Diagnosegröße bestimmt. Die den Messwerten zugrundeliegenden Messgrößen können z.B. Ströme-, Spannungen- und/oder Phasenwinkel sein.

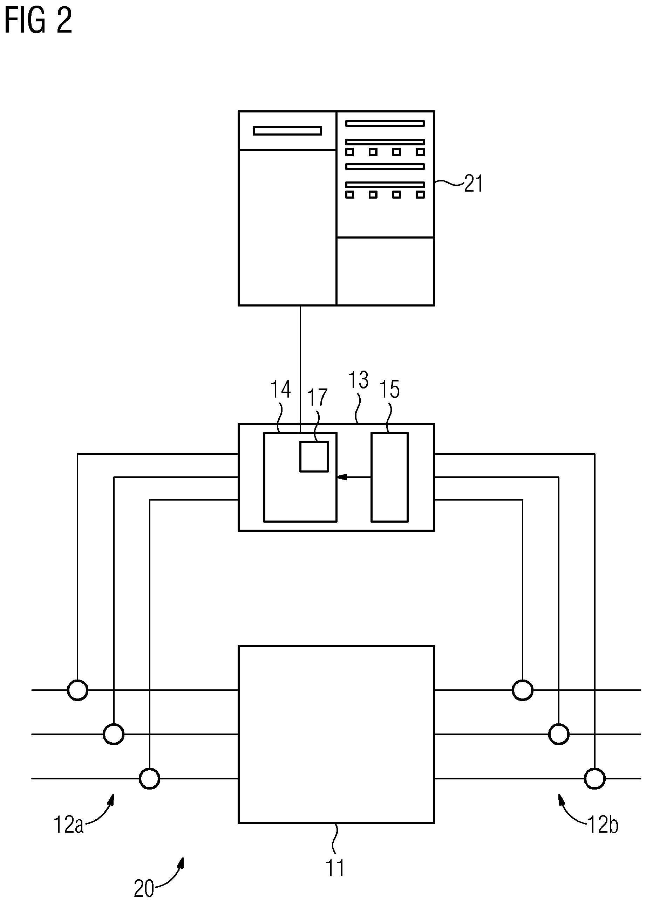

Figur 2 zeigt eine andere Ausführungsform eines Messsystems 20 zur Ermittlung einer Diagnosegröße an einem lokalen Betriebsmittel 11. In Figuren 1 und 2 einander entsprechende oder vergleichbare Komponenten sind mit denselben Bezugszeichen gekennzeichnet.

Der wesentliche Unterschied des Messsystems 20 von dem Messsystem 10 der Figur 1 besteht darin, dass die Auswertungseinrichtung nicht in der Messeinrichtung 13 selbst vorgesehen, sondern als zentrales Computersystem 21 ausgebildet ist. Dieses kann in Form einer Leitstelle, eines Stationsleitrechners oder auch eines Cloud-Computersystems ausgebildet sein und die Bestimmung der Diagnosegröße ausführen. Dazu werden dem zentralen Computersystem 21 die ersten und zweiten Messwerte von der Messeinrichtung 13 zugeführt.

Die weitere Funktionsweise des Messsystems 20 stimmt mit derjenigen des Messsystems 10 überein.

Somit kann mit den Messsystemen 10 und 20 der Figuren 1 und 2 ein Diagnoseverfahren durchgeführt werden, bei dem lokale Messeinrichtungen 13 allein oder im Zusammenspiel mit einem zentralen Computersystem 21 Aussagen über den Alterungszustand eines elektrischen Betriebsmittels 11 online, d.h. im Betrieb des Betriebsmittels 11, gewinnen können.

Die Messeinrichtung 13 und ggf. das zentrale Computersystem 21 werden dabei so gestaltet, dass sie auch in sekundären Verteilnetzen eingesetzt werden können, in denen heute die Zustandsüberwachung von elektrischen Betriebsmitteln 11 aus Kostengründen nicht möglich ist.

Das vorgeschlagene Verfahren beruht gemäß einer Ausführung auf einer Messung des Verlustfaktors des elektrischen Betriebsmittels 11. Um die hierfür heute üblicherweise erforderliche hochgenaue Zeitsynchronisation und die teure Übertragung von großen Datenmengen zu umgehen, wird das folgende Vorgehen vorgeschlagen:
Die Messeinrichtung 11 erfasst Signale von Messgrößen, z.B. mehrphasige Ströme und Spannungen am elektrischen Eingang bzw. Ausgang des elektrischen Betriebsmittels 11 mit einer sehr hohen Abtastrate, z.B. 1 Million Abtastwerte pro Sekunde. Im Falle von räumlich konzentrierten Betriebsmitteln (z.B. Transformatoren, Generatoren, Motoren, Schaltern) wird die Messeinrichtung 13 so ausgeführt, dass es sowohl die Messungen auf der Eingangsseite als auch auf der Ausgangsseite entgegennimmt.

Die Messeinrichtung 13 umfasst einen Zeitgeber 15, bei dem es sich z.B. um ein preiswertes Funkuhrmodul handeln kann, dessen Zeitsynchronisierung beispielsweise auf Basis des DCF77-Signals, das per Langwelle ausgestrahlt wird, erfolgen kann. Ein solcher kostengünstiger Zeitgeber ist üblicherweise nicht genau genug für eine Anwendung in Energieautomatisierungssystemen. Durch die hier vorgeschlagene Verwendung kann jedoch eine Benutzung eines solchen Zeitgebers ermöglicht werden.

Zu vorbestimmten Zeitpunkten, die bei der Konfiguration der Messeinrichtung 13 definiert werden, tastet die Messeinrichtung 13 z.B. die Signale der angeschlossenen Strom- und Spannungssensoren unter Gewinnung von Strom- und Spannungswerten ab und legt diese zunächst in einem internen Speicher 17 ab.

Im Falle von lokal konzentrierten Betriebsmitteln 11 kann die Auswertung der Messungen prinzipiell in der Messeinrichtung 13 selbst erfolgen (Figur 1). Dazu werden aus den zeitlich zusammengehörenden Messwerten die spezifischen Parameter des Betriebsmittels, z.B. hinsichtlich des Isolationsmediums, z.B. in Form eines Verlustfaktors oder einer charakteristischen Impedanz des Systemersatzschaltbildes des Betriebsmittels, bestimmt. Hierzu können beispielsweise ausgehend von zeitlich zueinander gehörenden Strom- und Spannungsmesswerten, die am Eingang und Ausgang des Betriebsmittels 11 in mehreren vordefinierten Zeitpunkten aufgenommen worden sind, die Verlustfaktoren oder charakteristischen Impedanzen des beobachteten Betriebsmittels 11 berechnet und damit die Parameter eines zugehörigen Systemersatzschaltbilds ermittelt werden.

Im Laufe der Betriebsjahre verändern sich die berechneten Verlustfaktoren oder charakteristischen Impedanzen oder deren Anteile (realer bzw. imaginärer Anteil) und deuten dadurch auf einen Alterungsprozess hin.

Im Falle eines Transformators als Betriebsmittel besteht das Betriebsmittel hierbei beispielsweise aus dem eigentlichen Transformator und dazugehörigen Durchführungen. Durch weitere Bearbeitung der Verlustfaktoren oder charakteristischen Impedanzen werden die Verluste, die in jede der Durchführung und in der Transformatorisolation selbst entstehen, berechnet.

Weiterhin ist es möglich, unterschiedliche physikalische Prozesse in der Isolation zu beobachten, die zusätzliche Informationen und Verfeinerungen der diagnostischen Aussagen ermöglichen. So können zum Beispiel Messungen bei unterschiedlichen Lasten (und damit unterschiedlichen Temperaturen des Isolationsmediums) z.B. ein Impedanzen- oder Verlustfaktor-Temperaturspektrum liefern, dessen Auswertung den Zustand des Öles bzw. des Isolationspapiers ergibt.

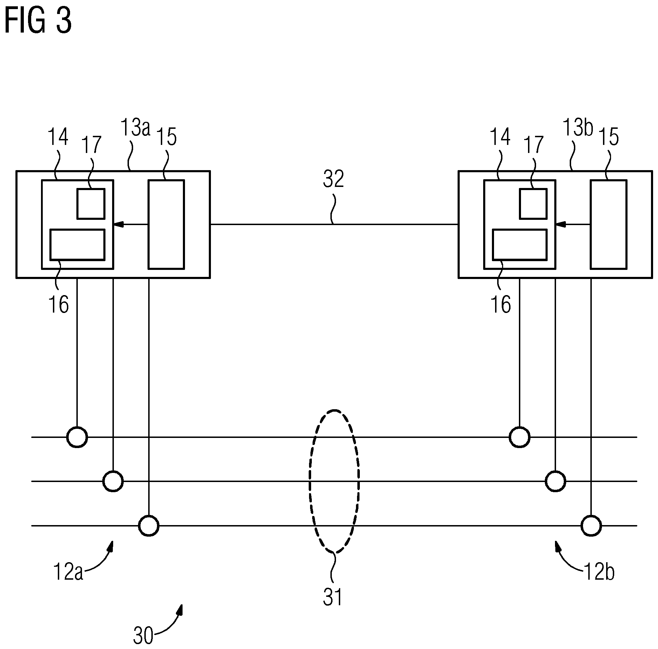

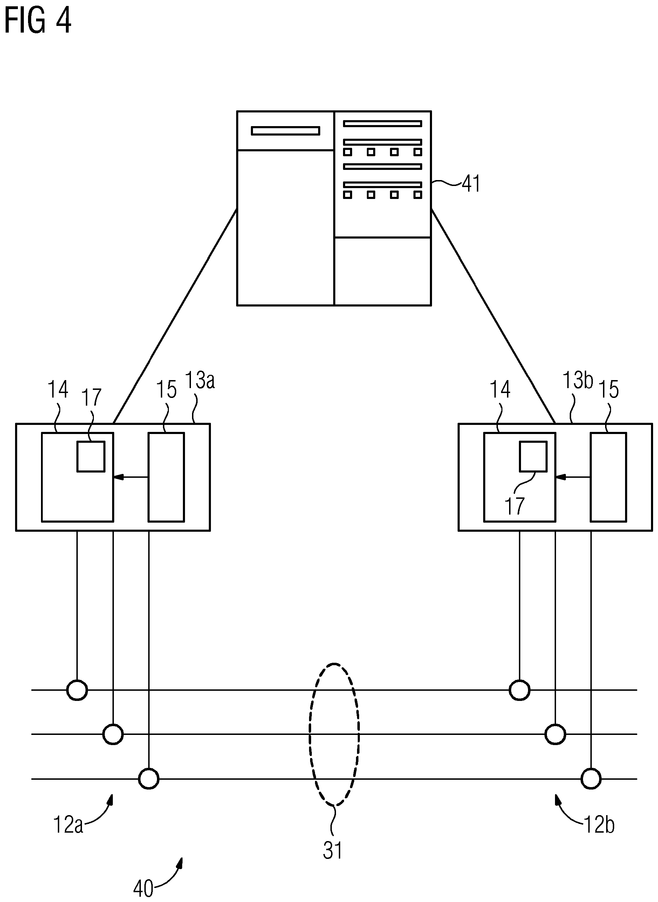

In den Figuren 3 und 4 sind andere Ausführungsformen des Messsystems gezeigt, bei denen die Messstellen räumlich voneinander entfernt angeordnet sind. Grundsätzlich entspricht die Funktionsweise derjenigen, die bereits zu Figuren 1 und 2 beschrieben worden ist. Einander entsprechende oder vergleichbare Elemente sind daher mit denselben Bezugszeichen versehen.

Figur 30 zeigt ein Messsystem 30, das zur Ermittlung einer Diagnosegröße an einem räumlich verteilten Betriebsmittel 31 dient. Bei einem solchen räumlich verteilten Betriebsmittel kann es sich z.B. um ein Kabel oder um eine Freileitung handeln. Die am Eingang und Ausgang des Betriebsmittels 31 angeordneten Messstellen 12a und 12b liegen somit zueinander in vergleichsweise großer Entfernung, so dass die Erfassung der Signale der Messgrößen mit einer einzigen Messeinrichtung nicht praktikabel und zudem auch mit Messfehlern versehen wäre.

Daher findet die Erfassung der Signale der Messgrößen entsprechend mit zwei Messeinrichtungen 13a und 13b statt, die jeweils in räumlicher Nähe zur jeweiligen Messstelle 12a, 12b angeordnet sind. Konkret werden mit der ersten Messeinrichtung 13a erste Messwerte an der ersten Messstelle 12a und mit der zweiten Messeinrichtung 13b zweite Messwerte an der zweiten Messstelle 12a erfasst.

Jede der Messeinrichtungen 13a, 13b ist entsprechend der zu Figur 1 erläuterten Messeinrichtung 13 ausgebildet. Um trotz kostengünstiger und vergleichsweise ungenauer Zeitgeber 15 für die Ermittlung der Diagnosegröße geeignete erste und zweite Messwerte zu verwenden, findet eine nachträgliche zeitliche Synchronisation mittels einer Synchronisiereinrichtung, die z.B. Bestandteil der Auswertungseinrichtung sein kann, statt, mit der jeweils solche Messwertpaare ermittelt werden, deren Messwerte gleichzeitig erfasst worden sind.

Bei dem Ausführungsbeispiel gemäß Figur 3 findet die Ermittlung der Diagnosegröße in einer der Messeinrichtungen 13a, 13b oder in beiden Messeinrichtungen 13a, 13b statt. Hierzu werden die Messwerte von über eine Kommunikationsverbindung 32, die drahtlos oder drahtgebunden ausgeführt sein kann, zwischen den Messeinrichtungen 13a, 13b übertragen und die nachträgliche Synchronisation durchgeführt. Danach wird mit den aufgefundenen Messwertpaaren die Diagnosegröße ermittelt.

Figur 4 zeigt eine andere Ausführungsform eines Messsystems zur Ermittlung einer Diagnosegröße an einem verteilt angeordneten Betriebsmittel 31. In Figuren 3 und 4 einander entsprechende oder vergleichbare Komponenten sind wiederum mit denselben Bezugszeichen gekennzeichnet.

Der wesentliche Unterschied des Messsystems 40 der Figur 4 von dem Messsystem 30 der Figur 3 besteht darin, dass die Auswertungseinrichtung nicht in einer oder beiden Messeinrichtungen 13a, 13b selbst vorgesehen, sondern wie bei dem Ausführungsbeispiel nach Figur 2 als zentrales Computersystem 41 ausgebildet ist. Dieses kann in Form einer Leitstelle, eines Stationsleitrechners oder auch eines Cloud-Computersystems ausgebildet sein und die Bestimmung der Diagnosegröße ausführen. Dazu werden dem zentralen Computersystem 41 die ersten und zweiten Messwerte von den Messeinrichtung 13a, 13b zugeführt.

Die weitere Funktionsweise des Messsystems 40 stimmt mit derjenigen des Messsystems 30 überein.

Somit kann mit den Messsystemen 30 und 40 der Figuren 3 und 4 ein Diagnoseverfahren durchgeführt werden, bei dem räumlich verteilt angeordnete Messeinrichtungen 13a, 13b allein oder im Zusammenspiel mit einem zentralen Computersystem 41 Aussagen über den Alterungszustand eines elektrischen Betriebsmittels 31 online, d.h. im Betrieb des Betriebsmittels 31, gewinnen können.

Generell ist es somit bei räumlich einem verteilten Betriebsmittel 31 vonnöten, die Messwerte vom Eingang und vom Ausgang des Betriebsmittels zusammenzuführen. Dazu übertragen die Messeinrichtungen 13a, 13b ihre Messwerte entweder untereinander oder an das zentrale Computersystem 41. Für die Bestimmung der Diagnosegröße, z.B. des Verlustfaktors, würde es ausreichen, nur jeweils ein Messwertpaar von Strom und Spannung zusammenzuführen. Jedoch müssen die Messwerte zu demselben Zeitpunkt aufgenommen worden sein, also im Rahmen einer sehr hohen Zeitgenauigkeit zeitsynchron sein. Die wie beschrieben in den Messeinrichtungen zum Einsatz kommenden vergleichsweise einfachen Zeitgeber, z.B. Funkuhrmodule weisen im Allgemeinen jedoch nur eine Zeitgenauigkeit von ±0,1s auf.

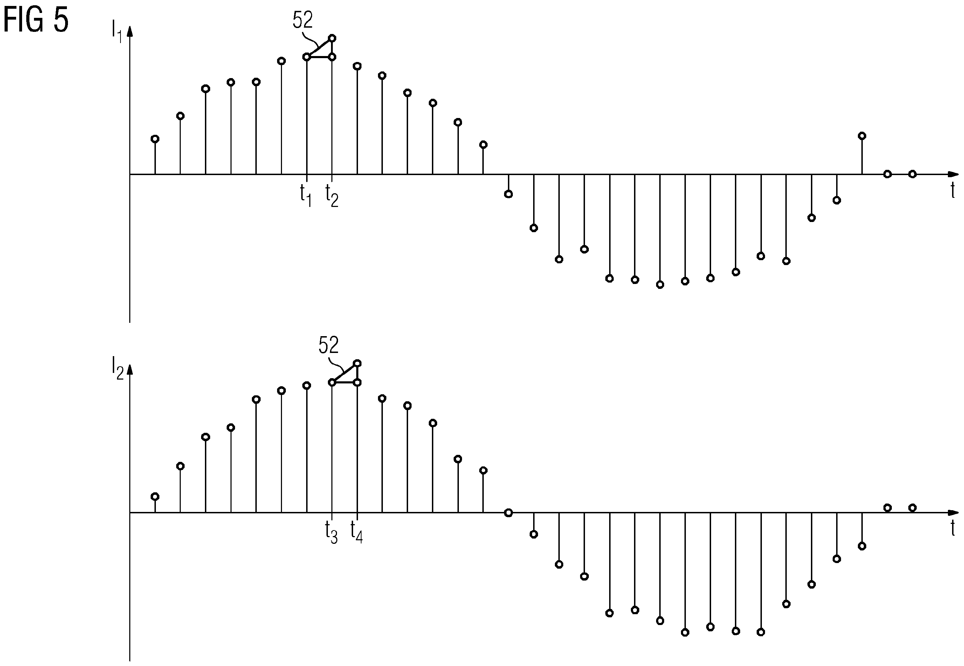

Aus diesem Grund wird das folgende Vorgehen vorgeschlagen: Während eines Konfigurationsvorgangs, z.B. bei der Inbetriebsetzung des Messsystems 30, 40 wird bei den Messeinrichtungen 13a, 13b ein zeitliches Messfenster parametriert, innerhalb dessen die beiden Messeinrichtungen 13a, 13b die Messwerte, z.B. Strom- und Spannungswerte, abtasten. Dies erfolgt durch Vorgabe eines Zeitpunktes und einer Messdauer, z.B. täglich von 12:00:00 bis 12:00:02 (hh:mm:ss). Die Zeitgeber in beiden Messeinrichtungen 13a, 13b haben im Allgemeinen einen Zeitversatz, der durch die Ungenauigkeit ihrer Zeitmessung verursacht wird. Damit werden die Verläufe der ersten und zweiten Messwerte zueinander nicht zeitsynchron erfasst. Diese Verläufe sind in Figur 5 beispielhaft für erste und zweite Strommesswerte I₁ und I₂ dargestellt. Wichtig ist, dass die Messdauer hierbei so gewählt wird, dass sich die Messfenster beider Messeinrichtungen 13a, 13b zumindest in einem Teilberteich überlappen.

Durch die kapazitiven und induktiven Eigenschaften des Betriebsmittels kommt es zu einer Phasenverschiebung der Größen, so dass die Extremwerte der Spannungen und Ströme (und damit auch alle anderen Werte der Sinuskurve) zu unterschiedlichen Zeitpunkten vorliegen. Die Amplitudengradienten werden allerdings nicht dadurch beeinflusst. Damit kann mit Hilfe der Amplitudenänderungen, die durch das Rauschen der zu messenden Größen verursacht werden, auf zeitlich zueinander gehörende Messwerte geschlossen und damit eine nachträgliche Zeitsynchronisierung vorgenommen werden.

Um die jeweils zeitlich zueinander passenden, also am Eingang und Ausgang des Betriebsmittels 31 absolut gesehen gleichzeitig erfassten ersten und zweiten Messwerte einander zuordnen und damit ein Messwertpaar bilden zu können, wird daher aus dem jeweiligen Verlauf der ersten und zweiten Messwerte jeweils die erste Ableitung gebildet, d.h. der Gradient des Messwertes von einem Abtastintervall zum nächsten. Die Messwertpaare, die zum Zeitpunkt der größten Gradienten (in Figur 5 angedeutet durch ein jeweiliges Dreieck 51, 52, mit dem die Steigung der Verläufe symbolisiert wird) vorliegen, werden an die Auswerteeinrichtung übermittelt. In Figur 5 liegen diese Messwertpaare bei den Zeitpunkten t₁ und t₃ sowie t₂ und t₄ vor.

Weitere Messwertpaare, die innerhalb eines Zeitbereichs innerhalb des Ungenauigkeitsbereiches des jeweilige Zeitgebers 15 liegen und die einen annähernd gleich großen Gradienten aufweisen, werden dann im weiteren Verlauf als zueinander zeitsysnchron und damit passend für die Ermittlung der Diagnosegröße (z.B. Verlustfaktorberechnung) angenommen.

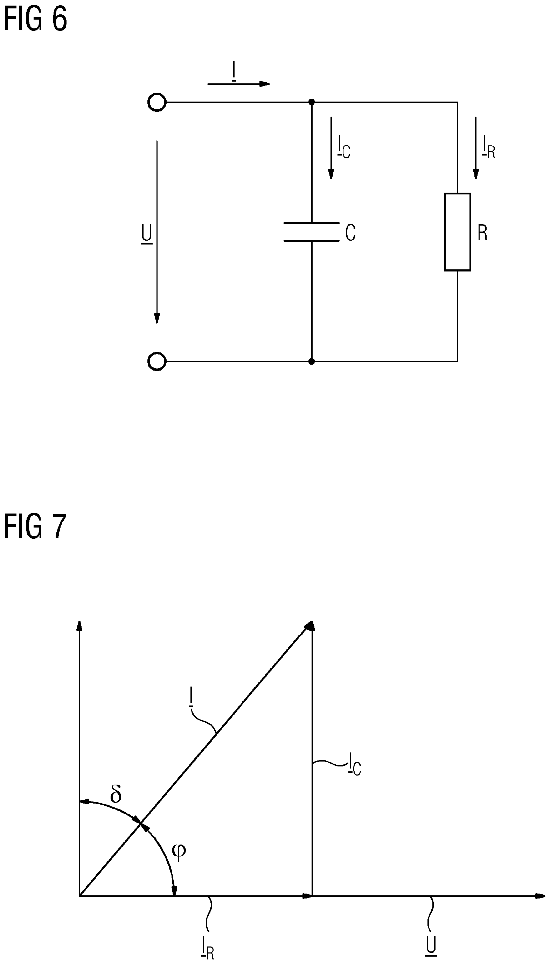

Figur 6 zeigt in schematischer Darstellung ein Ersatzschaltbild eines Betriebsmittels mit fließendem Strom I, anliegender Spannung U, sowie kapazitiven (Ic, C) und ohmschen ((IR, R) Anteilen. Durch Messung der Messgrößen Strom und Spannung am Eingang und Ausgang des Betriebsmittels kann auf den Alterungszustand des Betriebsmittels geschlossen werden.

Für das Beispiel des Verlustfaktors zeigt Figur 7 beispielhaft ein Diagramm, aus dem sich der Verlustfaktor als Tangens des Verlustwinkels δ bestimmen lässt. Durch Messung von Strömen und Spannungen an beiden Messstellen lassen sich die in Figur 7 gezeigten Stromzeiger im Verhältnis zum Spannungszeiger und damit der Verlustwinkel δ ermitteln.

Mit Hilfe z.B. der über einen Zeitraum (z.B. ein Jahr) gemessenen Verlustfaktoren werden dann die Alterungszustände der Betriebsmittel bestimmt. Dazu hält entweder die in einer Messeinrichtung vorgesehene Auswerteeinrichtung oder das zentrale Computersystem eine Sammlung von Alterungsmodellen (z.B. betriebsmittelspezifische Schwellenwerte der Diagnosegröße) vor, die genutzt werden, um aus den ermittelten Diagnosegrößen bzw. dem zeitlichen Verlauf der Diagnosegrößen auf die Restlebensdauer der Betriebsmittel unter Berücksichtigung der zu erwartenden Belastung zurückzuschließen.

Mit dem beschriebenen Verfahren kann somit eine kontinuierliche Überwachung des Alterungszustandes eines elektrischen Betriebsmittels erfolgen. Es sind dabei keine aufwendigen Maßnahmen zur Zeitsynchronisierung in den Messeinrichtungen notwendig. Zwischen den Messeinrichtungen bzw. einer Messeinrichtung und einem zentralen Computersystem werden nur geringe Datenmengen ausgetauscht. Optional kann bei bestimmten Betriebsmitteln (z.B. Transformatoren) gleichzeitig eine Bestimmung des Zustandes von Durchführungen, Öl und Papierisolierung durchgeführt werden.

Obwohl die Erfindung vorstehend im Detail durch bevorzugte Ausführungsbeispiele näher illustriert und beschrieben worden ist, ist die Erfindung nicht durch die offenbarten Beispiele eingeschränkt und andere Variationen können vom Fachmann hieraus abgeleitet werden, ohne den Schutzumfang der nachfolgenden Patentansprüche zu verlassen.

## Patentansprüche

1. Verfahren zum Ermitteln zumindest einer Diagnosegröße, die einen Alterungszustand eines Betriebsmittels (11, 31) in einem elektrischen Energieversorgungsnetz angibt, bei dem
- an einer ersten Messstelle (12a) des Betriebsmittels (11, 31) erste Messwerte zumindest einer Messgröße erfasst werden;
- an einer zweiten Messstelle (12b) des Betriebsmittels (11, 31) zweite Messwerte der zumindest einen Messgröße erfasst werden; und
- unter Verwendung jeweils gleichzeitig erfasster erster und zweiter Messwerte die zumindest eine Diagnosegröße ermittelt wird;
**dadurch gekennzeichnet, dass**
- die Erfassung der ersten und zweiten Messwerte zeitgesteuert in der Weise erfolgt, dass ein Signal der zumindest einen Messgröße mit einer vorgegebenen Abtastrate zu festgelegten Zeitpunkten und während einer festgelegten Messdauer unter Erzeugung von zeitlichen Verläufen der ersten und zweiten Messwerte abgetastet werden, wobei
- die erste und die zweite Messstelle (12a, 12b) des Betriebsmittels (31) räumlich voneinander entfernt angeordnet sind; und
- die ersten Messwerte mittels einer ersten Messeinrichtung (13a) und die zweiten Messwerte mittels einer zweiten Messeinrichtung (13b) erfasst werden,
- die festgelegten Zeitpunkte und Messdauern zur Erfassung der Messwerte der ersten und der zweiten Messwerte zeitlich derart festgelegt werden, dass die zeitgesteuerte Erfassung der Messwerte zumindest während eines Überlappungs-Zeitbereichs in den beiden Messeinrichtungen (13a, 13b) gleichzeitig erfolgt; und wobei
- die Verläufe der ersten und zweiten Messwerte abgespeichert und durch nachträgliche Synchronisierung aus den Verläufen jeweils gleichzeitig erfasste Messwertpaare der zumindest einen Messgröße ermittelt werden.

2. Verfahren nach Anspruch 1,
**dadurch gekennzeichnet, dass**
- die festgelegten Zeitpunkte und/oder die festgelegte Messdauer durch eine Konfiguration vorgegeben wird.

3. Verfahren nach Anspruch 1 oder 2,
**dadurch gekennzeichnet, dass**
- als Messgröße ein elektrischer Strom, eine elektrische Spannung und/oder ein Phasenwinkel an der ersten und zweiten Messstelle des Betriebsmittels (11, 31) verwendet werden.

4. Verfahren nach einem der vorangehenden Ansprüche,
**dadurch gekennzeichnet, dass**
- die zumindest eine Diagnosegröße in Form eines Verlustfaktors des Betriebsmittels (11, 31) oder einer charakteristischen Impedanz eines Systemersatzschaltbildes des Betriebsmittels (11, 31) ermittelt wird.

5. Verfahren nach einem der vorangehenden Ansprüche,
**dadurch gekennzeichnet, dass**
- die erste und die zweite Messeinrichtung (13a, 13b) jeweils einen Zeitgeber (15) umfassen, der die zeitgesteuerte Erfassung der Messwerte steuert.

6. Verfahren nach Anspruch 5,
**dadurch gekennzeichnet, dass**
- der jeweilige Zeitgeber (15) mittels eines Synchronisiersignals auf eine externe Zeitquelle abgestimmt wird.

7. Verfahren nach einem der vorangehenden Ansprüche,
**dadurch gekennzeichnet, dass**
- zur nachträglichen Synchronisierung aus den Verläufen der ersten und zweiten Messwerte jeweils die erste zeitliche Ableitung gebildet wird;
- in jedem Verlauf der abgeleiteten Messwerte das Maximum und der zugehörige Zeitpunkt, zu dem das Maximum in dem jeweiligen Verlauf auftritt, ermittelt werden; und
- diejenigen Messwerte, die zum Zeitpunkt des jeweiligen Maximums erfasst worden sind, als gleichzeitig erfasstes Messwertpaar verwendet werden.

8. Verfahren nach Anspruch 7,
**dadurch gekennzeichnet, dass**
- mindestens dasjenige Messwertpaar, das zum Zeitpunkt des jeweiligen Maximums erfasst worden ist, an eine Auswertungseinrichtung (16, 21, 41) übermittelt werden; und
- mit der Auswertungseinrichtung (16, 21, 41) die zumindest eine Diagnosegröße ermittelt wird.

9. Messeinrichtung (13, 13a, 13b) zum Erfassen von Messwerten in einem elektrischen Energieversorgungsnetz, mit
- einer Abtasteinrichtung (14) zur Abtastung eines Signals zumindest einer elektrischen Messgröße unter Verwendung einer vorgegebenen Abtastrate;
**gekennzeichnet durch**
- einen Zeitgeber (15), der dazu eingerichtet ist, die Erfassung der Messwerte zeitgesteuert in der Weise durchzuführen, dass das Signal der Messgröße mit einer vorgegebenen Abtastrate zu festgelegten Zeitpunkten und während einer festgelegten Messdauer unter Erzeugung eines zeitlichen Verlaufs der Messwerte abgetastet werden;
- eine Speichereinrichtung (17) zum Abspeichern der Verläufe der Messwerte; und
- eine Synchronisiereinrichtung, die zur nachträglichen Synchronisierung der abgespeicherten Verläufe mit solchen Verläufen von Messwerten der Messgröße eingerichtet ist, die von einer zweiten Messeinrichtung empfangen worden sind; wobei die Messeinrichtung dazu eingerichtet ist, ein Verfahren nach einem der Ansprüche 1-8 auszuführen.

10. Messsystem (10, 20, 30, 40) zum Ermitteln zumindest einer Diagnosegröße mit zumindest zwei nach Anspruch 9 ausgebildeten Messeinrichtungen (13a, 13b), mit
- einer Synchronisiereinrichtung, die dazu ausgebildet ist, durch nachträgliche Synchronisierung aus den Verläufen der Messwerte jeweils gleichzeitig in den Messeinrichtungen (13a, 13b) erfasste Messwertpaare zu ermitteln, indem sie in jedem Verlauf der Messwerte jeweils die erste zeitliche Ableitung bildet, in jedem Verlauf der abgeleiteten Messwerte das Maximum ermittelt und diejenigen Messwerte, die zum Zeitpunkt des jeweiligen Maximums erfasst worden sind, als gleichzeitig erfasstes Messwertpaar verwendet; und
- einer Auswertungseinrichtung (16, 21, 41) vorgesehen ist, die dazu eingerichtet ist, die zumindest eine Diagnosegröße zumindest aus dem gleichzeitig erfassten Messwertpaar zu ermitteln.

## Claims

1. Method for identifying at least one diagnosis variable, which indicates an ageing state of an operating means (11, 31) in an electrical energy supply network, in which
- first measurement values of at least one measurement variable are detected at a first measuring point (12a) of the operating means (11, 31);
- second measurement values of the at least one measurement variable are detected at a second measuring point (12b) of the operating means (11, 31); and
- the at least one diagnosis variable is identified using respective simultaneously detected first and second measurement values;
**characterized in that**
- the first and second measurement values are detected in a time-controlled manner in such a way that a signal of the at least one measurement variable is sampled at a prescribed sampling rate at set times and over a set measurement duration so as to generate time profiles of the first and second measurement values, wherein
- the first and the second measuring point (12a, 12b) of the operating means (31) are arranged at a physical distance from one another; and
- the first measurement values are detected by means of a first measuring device (13a) and the second measurement values are detected by means of a second measuring device (13b),
- the set times and measurement durations for detecting the measurement values of the first and the second measurement values are set in terms of time in such a way that the measurement values are detected simultaneously in a time-controlled manner at least over an overlap time range in the two measuring devices (13a, 13b); and wherein
- the profiles of the first and second measurement values are stored and, by subsequent synchronization, respective simultaneously detected measurement value pairs of the at least one measurement variable are identified from the profiles.

2. Method according to Claim 1,
**characterized in that**
- the set times and/or the set measurement duration is prescribed by a configuration.

3. Method according to Claim 1 or 2,
**characterized in that**
- the measurement variable used is an electric current, an electrical voltage and/or a phase angle at the first and second measuring point of the operating means (11, 31) .

4. Method according to one of the preceding claims,
**characterized in that**
- the at least one diagnosis variable is identified in the form of a dissipation factor of the operating means (11, 31) or of a characteristic impedance of a system equivalent circuit diagram of the operating means (11, 31) .

5. Method according to one of the preceding claims,
**characterized in that**
- the first and the second measuring device (13a, 13b) each comprise a timer (15), which controls the time-controlled detection of the measurement values.

6. Method according to Claim 5,
**characterized in that**
- the respective timer (15) is coordinated with an external time source by means of a synchronization signal.

7. Method according to one of the preceding claims,
**characterized in that**
- in each case the first time derivative is formed from the profiles of the first and second measurement values for the subsequent synchronization;
- the maximum and the associated time at which the maximum occurs in the respective profile are identified in each profile of the derived measurement values; and
- those measurement values that have been detected at the time of the respective maximum are used as the simultaneously detected measurement value pair.

8. Method according to Claim 7,
**characterized in that**
- at least that measurement value pair that has been detected at the time of the respective maximum is transmitted to an evaluation device (16, 21, 41); and
- the at least one diagnosis variable is identified using the evaluation device (16, 21, 41).

9. Measuring device (13, 13a, 13b) for detecting measurement values in an electrical energy supply network, having
- a sampling device (14) for sampling a signal of at least one electrical measurement variable using a prescribed sampling rate;
**characterized by**
- a timer (15), which is configured to detect the measurement values in a time-controlled manner in such a way that the signal of the measurement variable is sampled at a prescribed sampling rate at set times and over a set measurement duration so as to generate a time profile of the measurement values;
- a storage device (17) for storing the profiles of the measurement values; and
- a synchronization device, which is configured to subsequently synchronize the stored profiles with those profiles of measurement values of the measurement variable that have been received from a second measurement device; wherein the measurement device is configured to perform a method according to one of Claims 1 to 8.

10. Measuring system (10, 20, 30, 40) for identifying at least one diagnosis variable, having at least two measuring devices (13a, 13b) designed according to Claim 9, having
- a synchronization device that is designed, by subsequent synchronization, to identify respective measurement value pairs detected simultaneously in the measuring devices (13a, 13b) from the profiles of the measurement values by virtue of the fact that said synchronization device forms in each case the first time derivative in each profile of the measurement values, identifies the maximum in each profile of the derived measurement values and uses those measurement values that have been detected at the time of the respective maximum as the simultaneously detected measurement value pair; and
- an evaluation device 3(16, 21, 41) is provided, which is configured to identify the at least one diagnosis variable at least from the simultaneously detected measurement value pair.

## Revendications

1. Procédé de détermination d'au moins une grandeur de diagnostic, qui indique un état de vieillissement d'un moyen (11, 31) de fonctionnement dans un réseau d'alimentation en énergie électrique, dans lequel
- on relève au moins des premières valeurs de mesure d'au moins une grandeur de mesure en un premier point (12a) de mesure du moyen (11, 31) de fonctionnement ;
- on relève des deuxièmes valeurs de mesure d'au moins une grandeur de mesure en un deuxième point (12b) de mesure du moyen (11, 31) de fonctionnement ; et
- en utilisant, respectivement, des premières et deuxièmes valeurs de mesure relevées simultanément, on détermine la au moins une grandeur de diagnostic ;
**caractérisé en ce que**
- le relevé des premières et deuxièmes valeurs de mesure s'effectue d'une manière commandée dans le temps, par le fait qu'un signal d'au moins une grandeur de mesure est échantillonné à un taux d'échantillonnage donné à l'avance, à des instants fixés et pendant une durée de mesure fixée, en produisant des courbes en fonction du temps des premières et deuxièmes valeurs de mesure, dans lequel
- la premier et le deuxième points (12a, 12b) de mesure du moyen (31) de fonctionnement sont disposés en étant éloignés l'un de l'autre dans l'espace ; et
- on relève les premières valeurs de mesure au moyen d'un premier dispositif (13a) de mesure et les deuxièmes valeurs de mesure au moyen d'un deuxième dispositif (13b) de mesure,
- on fixe les instants et les durées de mesure fixés de relevé des valeurs de mesure des premières et des deuxièmes valeurs de mesure dans le temps, de manière à ce que le relevé commandé en fonction du temps des valeurs de mesure s'effectue simultanément dans les deux dispositifs (13a, 13b) de mesure pendant au moins un laps de temps de chevauchement ; et dans lequel
- on met en mémoire les courbes des premières et deuxièmes valeurs de mesure et on les détermine, par synchronisation ultérieure, à partir des courbes de paires de valeurs de mesure relevées simultanément de la au moins une grandeur de mesure.

2. Procédé suivant la revendication 1,
**caractérisé en ce que**
- on prescrit les instants fixés et/ou les durées de mesure fixées par une configuration.

3. Procédé suivant la revendication 1 ou 2,
**caractérisé en ce que**
- on utilise, comme grandeur de mesure, un courant électrique, une tension électrique et/ou un angle de phase au premier et deuxième point de mesure du moyen (11, 31) de fonctionnement.

4. Procédé suivant l'une des revendications précédentes,
**caractérisé en ce que**
- on détermine la au moins une grandeur de diagnostic sous la forme d'un facteur de perte du moyen (11, 31) de fonctionnement ou d'une impédance caractéristique d'un schéma équivalent de système du moyen (11, 31) de fonctionnement.

5. Procédé suivant l'une des revendications précédentes,
**caractérisé en ce que**
- le premier et le deuxième dispositifs (13a, 13b) de mesure comprennent chacun une horloge, qui commande le relevé commandé en fonction du temps des valeurs de mesure.

6. Procédé suivant la revendication 5,
**caractérisé en ce que**
- on accorde l'horloge (15) respective sur une source de temps extérieure au moyen d'un signal de synchronisation.

7. Procédé suivant l'une des revendications précédentes,
**caractérisé en ce que**
- pour la synchronisation ultérieure, on forme, à partir des courbes des premières et deuxièmes valeurs de mesure, respectivement, la première dérivée en fonction du temps ;
- on détermine, dans chaque courbe des valeurs de mesure dérivées, le maximum et l'instant associé où le maximum se produit dans la courbe respective ; et
- on utilise, comme paire de valeurs de mesure détectée simultanément, les valeurs de mesure, qui ont été relevées à l'instant du maximum respectif.

8. Procédé suivant la revendication 7,
**caractérisé en ce que**
- on transmet à un dispositif (16, 21, 41) d'exploitation, au moins la paire de valeurs de mesure, qui a été relevée à l'instant du maximum respectif ; et
- on détermine la au moins une grandeur de diagnostic par le dispositif (16, 21, 41) d'exploitation.

9. Dispositif (13, 13a, 13b) de mesure pour relever des valeurs de mesure dans un réseau d'alimentation en énergie électrique, comprenant
- un dispositif (14) d'échantillonnage pour l'échantillonnage d'un signal d'au moins une grandeur de mesure électrique, en utilisant un taux d'échantillonnage donné à l'avance ;
**caractérisé par**
- une horloge (15), conçue pour effectuer le relevé des valeurs de mesure d'une manière commandée en fonction du temps, de façon à échantillonner le signal de la grandeur de mesure à un taux d'échantillonnage donné à l'avance, à des instants fixés et pendant une durée de mesure fixée, en obtenant une courbe en fonction du temps des valeurs de mesure ;
- un dispositif (17) de mise en mémoire pour mettre en mémoire les courbes des valeurs de mesure ; et
- un dispositif de synchronisation, conçu pour la synchronisation ultérieure des courbes mises en mémoire avec des courbes de valeurs de mesure de la grandeur de mesure, qui ont été reçues par un deuxième dispositif de mesure, le dispositif de mesure étant conçu pour effectuer un procédé suivant l'une des revendications 1 à 8.

10. Système (10, 20, 30, 40) de mesure pour déterminer au moins une grandeur de diagnostic ayant au moins deux dispositifs (13a, 13b) de mesure constitués suivant la revendication 9, comprenant
- un dispositif de synchronisation, constitué pour déterminer, par synchronisation ultérieure, à partir des courbes des valeurs de mesure, des paires de valeurs de mesure relevées simultanément dans les dispositifs (13a, 13b) de mesure, en formant, dans chaque courbe des valeurs de mesure, respectivement, la première dérivée en fonction du temps, en déterminant, dans chaque courbe des valeurs de mesure dérivées, le maximum, et en utilisant, comme paire de valeurs de mesure relevée simultanément, les valeurs de mesure, qui ont été relevées à l'instant du maximum respectif ; et
- il est prévu un dispositif (16, 21, 41) d'exploitation, conçu pour déterminer au moins une grandeur de diagnostic, au moins à partir de la paire de valeurs de mesure relevée simultanément.
